(19) **Europäisches Patentamt / European Patent Office / Office européen des brevets**

(11) **EP 4 629 474 A1**

(12) # EUROPEAN PATENT APPLICATION

(43) Date of publication:
08.10.2025 Bulletin 2025/41

(21) Application number: 24168048.7

(22) Date of filing: 02.04.2024

(51) International Patent Classification (IPC):
*H02J 7/00* (2006.01)    *G01R 31/392* (2019.01)

(52) Cooperative Patent Classification (CPC):
H02J 7/005; G01R 31/367; G01R 31/392;
G01R 31/396

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Hitachi Energy Ltd
8050 Zürich (CH)

(72) Inventors:
• YANG, XiaoBo
Beijing, 100015 (CN)

• WEN, Jiang
Beijing, 102218 (CN)
• LU, Liu
Beijing, 100029 (CN)
• WANG, Yang
Beijing, 100024 (CN)
• YU, Lei
Beijing, 100083 (CN)
• CHEN, Niya
Beijing, 100016 (CN)

(74) Representative: Vossius & Partner
Patentanwälte Rechtsanwälte mbB
Siebertstrasse 3
81675 München (DE)

(54) **METHOD, STORAGE MEDIUM AND SYSTEM FOR CALIBRATING A STATE OF HEALTH OF A BATTERY STRING COMPRISING A PLURALITY OF CELLS**

(57) The present disclosure relates to a method for calibrating a state of health, SOHQ, of a battery string comprising a plurality of cells. The method comprises determining a new SOC at substantially full charge of each of the plurality of cells based on a look up table, LUT, of an initial state of charge, SOC, over an open circuit voltage, OCV, of each of the plurality of cells, determining a new SOC at substantially full discharge of each of the plurality of cells based on the LUT, and calibrating the battery string by determining a SOHQ based on the new SOC at full charge and the new SOC at full discharge. The disclosure also relates to a corresponding storage medium and battery energy storage system.

S1 establishing a look up table, LUT, of an initial state of charge, SOC, over an open circuit voltage, OCV, of each of the plurality of cells

↓

S2 determining a new SOC at substantially full charge of each of the plurality of cells

↓

S3 determining a new SOC at substantially full discharge of each of the plurality of cells

↓

S4 calibrating the battery string by determining a SOHQ based on the new SOC at full charge and the new SOC at full discharge

Fig. 1

EP 4 629 474 A1

**Description**

The present disclosure relates to a method, storage medium and system for calibrating a state of health of a battery string comprising a plurality of cells.

In particular, a solution for the calibration of a capacity-based state of health (SOHQ) of battery packs in a battery energy storage system (BESS) is proposed.

In existing systems, state of health (SOH) such as capacity-based state of health (SOHQ) indication can be used as an indicator of battery healthy status in a battery energy storage system (BESS). An SOHQ estimation method is the so-called Coulomb Counting method according to equation (1):

$$SOHQ = \frac{\int_{t0}^{t1} I(t)dt}{SOC(t1) - SOC(t0)} \qquad (1)$$

where SOC is the state-of-charge of battery in percentage, $SOC(t0)$ and $SOC(t1)$ are the SOC values at time points $t0$ and $t1$, respectively, and $I(t)$ is the battery current (charging is positive). The unit of SOHQ is the battery typical capacity or nominal capacity in Ampere-hour (Ah). The SOHQ may be normalised by the typical or nominal capacity of the battery.

In equation (1), both $SOC(t0)$ and $SOC(t1)$ are not measured values but estimated values as a function of the current battery capacity. It may therefore be difficult to use equation (1) directly for SOHQ calibration due to the error of SOC estimation.

To improve the SOC estimation, a full charge and discharge cycle may be used to calibrate the SOHQ. For example, the battery is charged to the maximum charging voltage under a specified charging current or charging power condition at t0, and $SOC(t0)$ is set to 100%. After a certain rest time, the battery is discharged to a cut-off voltage and the time the cut-off voltage is reached is denoted as t1. Consequently, $SOC(t1)$ is set to 0%. Equation (1) can be rewritten as:

$$SOHQ = \frac{\int_{t0}^{t1} I_{disch}(t)dt}{0\% - 100\%} \qquad (2a)$$

Here, $I_{disch}$ denotes the discharging current. The unit of SOHQ is the battery typical capacity or nominal capacity in Ampere-hour (Ah). The SOHQ may be normalised by the typical or nominal capacity of the battery.

Alternatively, the battery can first be fully discharged to the cut-off voltage and then fully charged. By setting the SOC values of 0% and 100% as above and knowing the charging current $I_{ch}$, equation (1) can be rewritten as:

$$SOHQ = \frac{\int_{t0}^{t1} I_{ch}(t)dt}{100\% - 0\%} \qquad (2b)$$

In that manner, the SOCs (0% and 100%) can be measured independently from SOHQ and equation (2) can be applied for the SOHQ calibration.

In particular, an SOHQ estimation using equation (2) may be of high accuracy for a single battery cell.

However, the above methods may not be suitable or accurate for SOH estimation of battery strings. The present disclosure has been made to remedy problems of existing systems.

There are two main challenges when applying equation (2) for an SOHQ calibration of a battery pack/battery string, i.e., a plurality of series connected cells:

1) There may exist inconsistency between the battery cells. When any of the battery cell in one battery string is discharged to cut-off voltage or charged to max charge voltage at first, the other cells in the same battery string may be not fully discharged to 0%, or full charged to 100%.

2) The full charge/discharge condition is difficult to obtain during a normal operation of the BESS on site, as it may be constrained by the grid code and the demand from ancillary service.

According to an embodiment, based on offline measurement data of an OCV-SOC (open circuit voltage - state of charge) curve, where the open circuit voltage (OCV) is a function of SOC under a given environment temperature, the SOC of not-fully-charged and not-fully-discharged battery cells can still be estimated with good accuracy via a look-up table based method.

Further, an SOHQ calibration procedure using equation (2) for SOHQ estimation is proposed, while reducing the impact on the grid and ancillary services to a minimum level. This is particularly applicable to large scale BESSs which may consist of several PCS (power conversion system) units at one site.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for calibrating a state of health, SOHQ, of a battery string comprising a plurality of cells. The method comprises determining a new SOC at substantially full charge of each of the plurality of cells based on a look up table, LUT, of an initial state of charge, SOC, over an open circuit voltage, OCV, of each of the plurality of cells, determining a new SOC at substantially full discharge of each of the plurality of cells based on the LUT, and calibrating the battery string by determining a SOHQ based on the new SOC at full charge and the new SOC at full discharge.

Various embodiments may preferably implement the following features.

In an embodiment, the new SOC at substantially full charge is determined prior to the new SOC at substantially full discharge.

In an embodiment, the new SOC at substantially full discharge is determined prior to the new SOC at substantially full charge.

In an embodiment, the method further comprises establishing or obtaining the LUT, preferably prior to determining the new SOC.

In an embodiment, the LUT is established while the battery string is offline.

In an embodiment, the LUT is established under a controlled temperature and the calibration is performed under the same controlled temperature.

In an embodiment, the LUT is established under a controlled charging rate and/or discharging rate and/or state of health, SoH, and the calibration is performed under the same controlled charging rate and/or discharging rate and/or SoH.

In an embodiment, the SOCs are established using a current integration method, in particular a coulomb counting method or ampere-hour integration method.

In an embodiment, full charge denotes a state in which a voltage of at least one of the plurality of cells is higher than a predetermined threshold $U_{max}$.

In an embodiment, full discharge denotes a state in which a voltage of at least one of the plurality of cells is lower than a predetermined threshold $U_{min}$.

In an embodiment, the SOHQ is a capacity-based state of health.

In an embodiment, the method further comprises providing, during calibration, a controlled amount of power to the battery string to be calibrated, preferably by a power distributer.

In an embodiment, calibrating the battery string further comprises determining an SOHQ for each of the plurality of cells.

In an embodiment, a lowest SOHQ value among the plurality of cells is determined as the SOHQ of the battery string. In an embodiment, an average value of the SOHQs of each of the plurality of cells is determined as the SOHQ of the battery string. In an embodiment, a normalised maximum available charging power is determined as the SOHQ of the battery string.

The present disclosure further relates to a computer-readable storage medium which, when read by a processor, instruct the processor to perform the method as described above.

The present disclosure further relates to a battery energy storage system, BESS, comprising at least one battery string comprising a plurality of battery cells, and a device comprising at least one processor, wherein the processor is configured to perform the method as described above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.

Fig. 1 shows a flow chart of a method according to an embodiment of the present disclosure.

Fig. 2 shows a BESS with multiple PCS units according to an embodiment of the present disclosure.

Fig. 3 shows a power order distributor according to an embodiment of the present disclosure.

The present disclosure relates to a method for calibrating a state of health (SOH) of a battery string comprising a plurality of cells. In particular, the disclosure relates to a capacity based state of health (SOHQ).

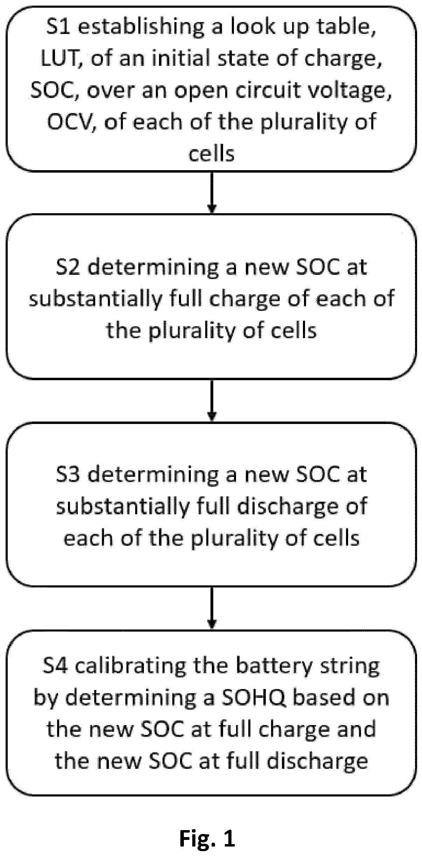

Fig. 1 shows a flowchart according to an embodiment. The method comprises determining (S2) a new SOC at substantially full charge of each of the plurality of cells based on a look up table (LUT) of the initial state of charge (SOC) over the open circuit voltage (OCV) of each of the plurality of cells and determining (S3) a new SOC at substantially full discharge of each of the plurality of cells based on the LUT. Subsequently, the battery string is calibrated (S4) by determining a SOHQ based on the new SOC at full charge and the new SOC at full discharge.

For determining the new SOCs, the battery cells may be fully charged to determine the new SOC at substantially full charge and then fully discharged to determine the new SOC at substantially full discharge. Alternatively, the battery cells may also be fully discharged to determine the new SOC at substantially full discharge and then fully charged to determine the new SOC at substantially full charge.

In other words, the new SOC at substantially full charge may be determined prior to the new SOC at substantially full discharge, or the new SOC at substantially full discharge may be determined prior to the new SOC at substantially full charge.

As used herein, the term substantially full charge may denote that at least one of the cells in the battery string reaches 100% SOC. Correspondingly, the term substantially full discharge may denote that at least one of the cells in the battery string reaches 0% SOC. 100% SOC and 0% SOC may be determined by an upper and lower threshold voltage, respectively.

As shown in Fig. 1, the method may further comprise establishing (S1) the look up table (LUT) of the initial state of charge (SOC) over the open circuit voltage (OCV) of each of the plurality of cells. Alternatively, the LUT may be externally provided, i.e., the method may comprise a step of obtaining (receiving) the LUT.

In particular, the LUT may map an SOC-OCV curve to a given SOHQ at certain (predetermined) temperatures.

The LUT may be established while the battery string is offline. That is, the battery string may not be connected to other battery strings of a BESS and/or may not be simultaneously used for purposes other than calibration, i.e., controlled charging and discharging. The LUT may also be established in a lab testing environment.

Moreover, the LUT may be established under a controlled temperature and the calibration is performed under the same controlled temperature. Such a temperature may be between 0°C - 60°C during charging and -20°C- 60°C during discharging, preferably 25°C. During generating the LUT and the calibration, a deviation within +/- 5°C, preferably +/- 2°C may be acceptable.

The temperature may be controlled by an air conditioning system and/or heat exchanger system.

The LUT may be established under a controlled charging rate and/or discharging rate and/or state of health, SoH, and the calibration is performed under the same controlled charging rate and/or discharging rate and/or SoH. The controlled charging/discharging rate may refer to a testing environment of the manufacturer or a lab which is then repeated or emulated for establishing the LUT and for calibration.

The SOCs may be established using a current integration method, in particular a coulomb counting method or ampere-hour integration method.

As outlined above, full charge of the battery string may denote a state in which a voltage of at least one of the plurality of cells is higher than a predetermined threshold $U_{max}$. Similarly, full discharge of the battery string may denote a state in which a voltage of at least one of the plurality of cells is lower than a predetermined threshold $U_{min}$.

The SOHQ is a capacity-based state of health.

The method may further comprise providing, during calibration, a controlled amount of power to the battery string to be calibrated, preferably by a power distributer. This controlled power may be determined by a charging rate and a battery string voltage.

Calibrating the battery string may further comprise determining an SOHQ for each of the plurality of cells. A lowest SOHQ value among the plurality of cells may be determined as the SOHQ of the battery string. Alternatively, an average value of the SOHQs of each of the plurality of cells may be determined as the SOHQ of the battery string. As a further option, a normalised maximum available charging power may be determined as the SOHQ of the battery string.

The present disclosure also relates to a computer-readable storage medium which, when read by a processor, instruct the processor to perform the method as described above.

Moreover, the present disclosure relates to a battery energy storage system (BESS) comprising at least one battery string comprising a plurality of battery cells and a device comprising at least one processor. The processor is configured to perform the method as described above.

The proposed method will be further described below.

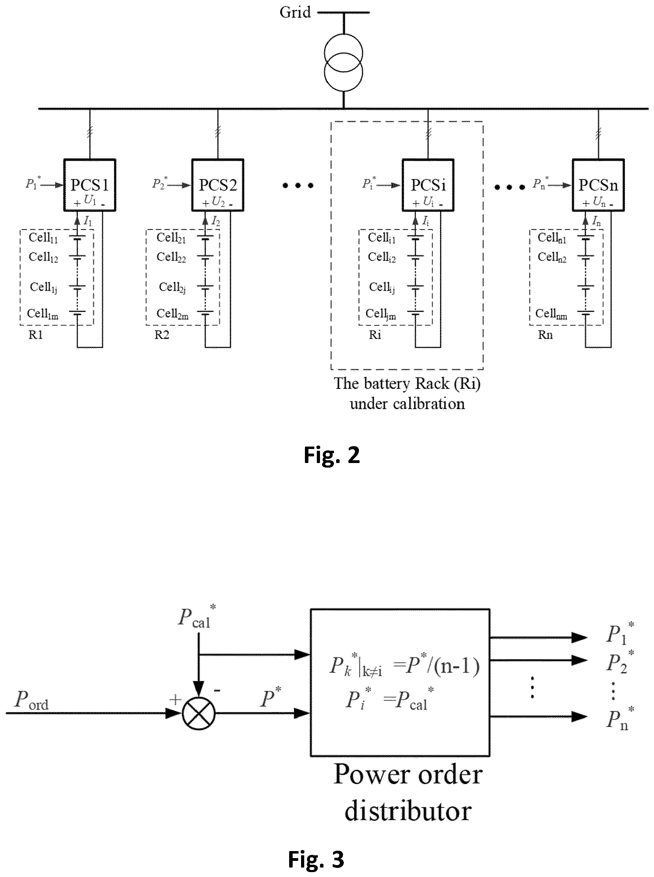

Fig. 2 shows a BESS with multiple PCS units according to an embodiment of the present disclosure. In Fig. 2, there are n PCS units in total (PCS1 - PCSn). Each PCS is connected with a battery rack, denoted as R1 - Rn respectively. The current of every battery rack is denoted as $I_i$, where $i \in [1..n]$. Each battery rack consists of m battery cells in series, denoted as $Cell_{i1}$, $Cell_{i2}$, ..., $Cell_{im}$, where the subscript i refers to the number of the battery rack. The voltage of each battery cell in rack Ri is denoted by $U_{i1}$, $U_{i2}$, ..., $U_{im}$, respectively.

Each PCS can be operated either under normal operation mode or under calibration mode. Under normal operation mode, each PCS will receive a normal power order from a high level controller, according to the demand from the ancillary service. The term power order may refer to a power provided to the battery rack. Under calibration mode, the PCS under calibration will receive a calibration power order $P_{cal}*$ from a power order distributer in the high-level controller of the BESS. A power order distributor according to an embodiment is shown in Fig. 3.

In the power order distributor according to an embodiment, the required power is re-distributed to all the PCS units which are under normal operation. The battery rack(s) under calibration mode will start the SOHQ calibration via its respective PCS unit. It may be advantageous that only one battery rack is selected for calibration in order to reduce the impact on the maximum available power provided by other PCS units under normal operation. By this way, the normal operation of the BESS system will not be substantially impacted. To avoid overloading of the PCS units under normal operation, the maximum power $P_{ord}$ may be reduced, depending on the total amount of PCS units in the system and the amount of battery racks under calibration at the same time. The order may also be a current.

In an embodiment, the method may be described by the following steps.

Before the calibration (step 0), a look-up table of SOC vs. OCV, i.e., SOC=LUT(OCV, SOHQ), which represents the SOC-OCV curve under given SOHQ at certain temperatures (e.g., 25°C) is established. The SOC-OCV curve can be obtained from off-line GITT (galvanostatic intermittent titration technique) and/or HPPC (Hybrid Pulse Power Characterisation) testing of the battery cell(s).

In step 1, a capacity of each battery cell is assigned to its initial value:

$$SOHQ[i,j]=SOHQ0[i,j],$$

where i is the number of battery rack, and j is the number of battery cells in one battery rack ($1<i\leq n$, $1\leq j\leq m$). SOHQ[i,j] and SOHQ0[i,j] represent the current battery cell capacity and initial battery cell capacity of $Cell_{ij}$, respectively.

In step 2, according to the calibration schedule defined in advance (e.g., weekly, monthly, annual calibration), the battery rack to be calibrated is selected and its operation mode is changed from normal operation mode to calibration mode. In the following, battery rack Ri denotes the battery rack to be calibrated.

During the calibration, the temperature of Ri is controlled (step 3), e.g., by using a battery cooling system to a constant temperature, which is the same as the temperature during offline SOC-OCV curve testing (e.g., 25°C).

In step 3, the battery rack Ri is fully charged to the maximum charging voltage under a given power order Pi. The fully charged condition of Ri may be defined as:

$$MAX(Ui1,Ui2,..,Uim)\geq U_{max} \tag{3}$$

where $U_{max}$ is the maximum charging voltage of the battery cell (upper threshold).

When Ri is (substantially) fully charged, this may be denoted as t0. After a predetermined idle time (e.g., between minutes, tens of minutes, or hours), the OCV of each cell in rack Ri is recorded and denoted as OCV_high[i,j]. The SOC of each battery cell at the full charge status of Ri can be obtained as:

$$SOC\_high[i,j]=LUT(OCV\_high[i,j],SOHQ[i,j]) \tag{4}$$

During the calibration in steps 4-5, the power order Pi is given by the proposed power order distributor (see Fig. 3), to ensure that the power demand is re-distributed to other PCS units.

In step 5, the battery Rack Ri is (substantially) fully discharged to a discharge cut-off voltage under given power order Pi. The fully charged condition of Ri may be defined as:

$$MIN(Ui1,Ui2,..,Uim)\leq U_{min} \tag{5}$$

where $U_{min}$ is the discharge cut-off voltage of the battery cell (lower threshold).

When Ri is fully discharged, this is denoted as t1. The OCV of each cell in Ri is recorded and denoted as OCV_low[i,j]. The SOC of each battery cell at the full discharge status of Ri can be obtained as:

$$SOC\_low[i,j]=LUT(OCV\_low[i,j],SOHQ[i,j]) \tag{6}$$

As mentioned above, the calibration may also be performed in reverse order and start in the discharged state.

In step 6, the new SOHQ is calculated based on equation (2) as

$$SOHQ\_new[i,j] = \frac{\int_{t0}^{t1} Ii(t)dt}{SOC\_high[i,j]-SOC\_low[i,j]} \tag{7}$$

where the current provided by (or to) the battery can be measured and given by a battery management system (BMS).

Subsequently, the SOHQ is updated with the new SOHQ:

$$SOHQ[i,j]=SOHQ\_new[i,j] \qquad (8)$$

which denotes the current SOHQ of each cell in rack Ri.

In step 7, the capacity-based SOH of rack Ri, SOHQ_R[i], is defined as the minimum SOHQ of all the cells, i.e.:

$$SOHQ\_R[i] = MIN(SOHQ\_new[i,j]) \qquad (9)$$

In an embodiment, the SOHQ_R[i] may be normalised by the typical or nominal capacity of the battery cell.

For the next cycle calibration, the method may return to step 2 above.

By using the proposed method, the rack SOHQ can be calibrated with minimum impact on the normal operation of BESS. Moreover, accuracy of the SOHQ may be improved.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**Claims**

1. Method for calibrating a state of health, SOHQ, of a battery string comprising a plurality of cells, the method comprising:

   determining (S2) a new SOC at substantially full charge of each of the plurality of cells based on a look up table, LUT, of an initial state of charge, SOC, over an open circuit voltage, OCV, of each of the plurality of cells, determining (S3) a new SOC at substantially full discharge of each of the plurality of cells based on the LUT, and calibrating (S4) the battery string by determining a SOHQ based on the new SOC at full charge and the new SOC at full discharge.

2. Method according to claim 1, wherein the new SOC at substantially full charge is determined prior to the new SOC at substantially full discharge, or
   wherein the new SOC at substantially full discharge is determined prior to the new SOC at substantially full charge.

3. Method according to claim 1 or 2, further comprising establishing (S1) the look up table or obtaining the look up table.

4. Method according to claim 3, wherein the LUT is established while the battery string is offline.

5. Method according to any one of claims 3 or 4, wherein the LUT is established under a controlled temperature and the calibration is performed under the same controlled temperature.

6. Method according to any one of claims 3 to 5, wherein the LUT is established under a controlled charging rate and/or discharging rate and/or state of health, SoH, and the calibration is performed under the same controlled charging rate and/or discharging rate and/or SoH.

7. Method according to any one of claims 1 to 5, wherein the SOCs are established using a current integration method, in particular a coulomb counting method or ampere-hour integration method.

8. Method according to any one of claims 1 to 7, wherein full charge denotes a state in which a voltage of at least one of the plurality of cells is higher than a predetermined threshold Umax.

9. Method according to any one of claims 1 to 8, wherein full discharge denotes a state in which a voltage of at least one of the plurality of cells is lower than a predetermined threshold $U_{min}$.

10. Method according to any one of claims 1 to 9, wherein the SOHQ is a capacity-based state of health.

11. Method according to any one of claims 1 to 10, further comprising providing, during calibration, a controlled amount of power to the battery string to be calibrated, preferably by a power distributer.

12. Method according to any one of claims 1 to 11, wherein calibrating the battery string further comprises determining an SOHQ for each of the plurality of cells, and

   wherein a lowest SOHQ value among the plurality of cells is determined as the SOHQ of the battery string, or an average value of the SOHQs of each of the plurality of cells is determined as the SOHQ of the battery string, or wherein a normalised maximum available charging power is determined as the SOHQ of the battery string.

13. Computer-readable storage medium which, when read by a processor, instruct the processor to perform the method according to any one of claims 1 to 12.

14. Battery energy storage system, BESS, comprising:

   at least one battery string comprising a plurality of battery cells, and
   a device comprising at least one processor,
   wherein the processor is configured to perform the method of any one of claims 1 to 12.

S1 establishing a look up table, LUT, of an initial state of charge, SOC, over an open circuit voltage, OCV, of each of the plurality of cells

S2 determining a new SOC at substantially full charge of each of the plurality of cells

S3 determining a new SOC at substantially full discharge of each of the plurality of cells

S4 calibrating the battery string by determining a SOHQ based on the new SOC at full charge and the new SOC at full discharge

**Fig. 1**

**Fig. 2**

**Fig. 3**

Europäisches
Patentamt

European
Patent Office

Office européen
des brevets

# EUROPEAN SEARCH REPORT

**Application Number**

EP 24 16 8048

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MA ZHAN ET AL: "Multilayer SOH Equalization Scheme for MMC Battery Energy Storage System", IEEE TRANSACTIONS ON POWER ELECTRONICS, INSTITUTE OF ELECTRICAL AND ELECTRONICS ENGINEERS, USA, vol. 35, no. 12, 1 May 2020 (2020-05-01), pages 13514-13527, XP011802926, ISSN: 0885-8993, DOI: 10.1109/TPEL.2020.2991879 [retrieved on 2020-08-04] * page 13514 - page 13519; figures 1,2,4,17,18; tables I, III-VIII * | 1-14 | INV. H02J7/00 G01R31/392 |
| X | XIN XIONG ET AL: "A novel practical state of charge estimation method: an adaptive improved ampere-hour method based on composite correction factor", INTERNATIONAL JOURNAL OF ENERGY RESEARCH, WILEY, CHICHESTER, GB, vol. 44, no. 14, 20 August 2020 (2020-08-20), pages 11385-11404, XP071645765, ISSN: 0363-907X, DOI: 10.1002/ER.5758 Parts 2 THEORETICAL ANALYSIS and 3 EXPERIMENTAL ANALYSIS; * abstract * | 1-14 | TECHNICAL FIELDS SEARCHED (IPC) H02J G01R |

The present search report has been drawn up for all claims

| Place of search | Date of completion of the search | Examiner |
|---|---|---|
| Munich | 19 September 2024 | Jäschke, Holger |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)